# EUROPÄISCHE PATENTSCHRIFT

(11) **EP 3 357 307 B1**
(45) Veröffentlichungstag und Bekanntmachung des Hinweises auf die Patenterteilung: **24.08.2022**
(21) Anmeldenummer: 16781690.9
(22) Anmeldetag: 27.09.2016
(51) Int. Cl.: H05K 1/02, H05K 1/18

(54) **LEUCHTANZEIGE**
LUMINOUS DISPLAY
AFFICHAGE LUMINEUX

(30) Priorität: 28.09.2015 DE 102015218610; 29.04.2016 DE 202016102308 U; 08.06.2016 DE 202016103036 U
(43) Veröffentlichungstag der Anmeldung: 08.08.2018
(73) Patentinhaber: LightnTec GmbH & Co. KG, 76131 Karlsruhe (DE)
(72) Erfinder: HÜBNER, Manuel, 76139 Karlsruhe (DE); KALL, Florian, 76337 Waldbronn (DE)
(74) Vertreter: Kohler Schmid Möbus Patentanwälte
(86) Internationale Anmeldenummer: PCT/EP2016/072994
(87) Internationale Veröffentlichungsnummer: WO 2017/055279

(56) Entgegenhaltungen:
- WO-A1-2007/087376
- DE-A1-102008 009 775
- US-A- 5 900 850
- US-A1- 2001 022 589
- US-A1- 2007 182 666
- US-A1- 2007 218 751
- US-A1- 2009 146 918
- US-A1- 2011 085 321
- US-A1- 2014 253 414
- US-A1- 2015 186 099
- US-A1- 2015 235 609

## Beschreibung

Die Erfindung betrifft eine Leuchtanzeige zur Darstellung eines Bildes oder Films. Die Erfindung betrifft weiterhin ein Verfahren zum Betrieb einer Leuchtanzeige und ein Verfahren zur Herstellung einer Leuchtanzeige.

Es ist bekannt, Leuchtanzeigen mit einer Vielzahl von Leuchtmitteln zu Werbezwecken einzusetzen. Beispielsweise ist aus der EP 2 400 822 B1 eine gattungsgemäße Leuchtanzeige bekannt geworden, bei der mehrere Leuchtmittel auf einem Grundkörper angeordnet sind. Ebenso zeigt die DE 10 2008 009775 A1 eine großflächige Leuchtanzeige, welche durch eine flexible Folie auf einem transparenten Substrat realisiert wird.

Die vorliegende Erfindung soll es ermöglichen eine flexibel auf Fassaden, Fensterscheiben oder dergleichen aufbringbare Leuchtanzeige bereit zu stellen.

Diese Aufgabe wird erfindungsgemäß durch eine Leuchtanzeige mit den Merkmalen des Patentanspruchs 1, einem Verfahren zur Herstellung einer solchen Leuchtanzeige gemäß Patentanspruch 11 und einem Verfahren zum Betrieb einer Leuchtanzeige gemäß Patentanspruch 13 gelöst. Die abhängigen Patentansprüche geben bevorzugte Weiterbildungen wieder.

Die Leiterbahnen zur elektrischen Versorgung der Leuchtmittel können zumindest einen Teil einer Bedeckung des Grundkörpers darstellen. Die Bedeckung besteht vorzugsweise aus einer Vielzahl von Strukturen. Die Strukturen an sich sind dabei für sichtbares Licht weitestgehend undurchlässig. Mit anderen Worten reduziert die Bedeckung bzw. die einzelnen Strukturen der Bedeckung sichtbares Licht um zumindest 80%. Die Bedeckung verhilft der Leuchtanzeige zu einer weitgehend gleichmäßigen mittleren optischen Durchlässigkeit. Hierzu bedecken die Strukturen der Bedeckung den Grundkörper zu 30% bis 60%. Die 30% bis 60% werden dabei in einem beliebig in der Hauptebene des Grundkörpers positionierten 1cm² großen Quadrat gemessen. In 85% der Fälle kann dabei das Quadrat so in der Hauptebene des Grundkörpers positioniert werden, dass die Strukturen 30% bis 60% des Grundkörpers bedecken.

Die gemittelte optische Durchlässigkeit, d.h. die Transparenz für sichtbares Licht, wird vorzugsweise durch die Bedeckung in 85% der Fälle in einem 1 cm² großen Quadrat der Leiterbahnanordnung um maximal 50%-70% reduziert. Das 1 cm² große Quadrat ist dabei frei in der Hauptebene der Leiterbahnanordnung bestimmbar. Die Bedeckung weist mehrere Strukturen auf, wobei die einzelnen Strukturen der Bedeckung die optische Durchlässigkeit um zumindest 80 % reduzieren. Hierdurch sind die einzelnen Strukturen der Bedeckung für das menschliche Auge in einem Abstand von mehr als 5m nicht mehr unterscheidbar, wodurch die Leuchtanzeige eine gleichmäßige optische Transparenz aufweist.

Die Strukturen der Bedeckung können verschiedene Geometrien aufweisen. Die Bedeckung kann weiterhin eine Farbe zur Lichtabsorption aufweisen. Besonders bevorzugt ist die Bedeckung in Form einer Metallisierung bzw. Metallisierungsstrukturen ausgebildet.

Vorzugsweise weist die Bedeckung vorwiegend Leiterbahnen auf. Durch die Bedeckung wird die gemittelte optische Durchlässigkeit der gesamten Leiterbahnanordnung vorzugsweise um maximal 70%, insbesondere um maximal 60%, weiter bevorzugt um maximal 50% reduziert.

In besonders bevorzugter Ausgestaltung der Erfindung weisen zumindest 60% der Leiterbahnabschnitte der Leiterbahnen den gleichen Abstand zu ihrem jeweils nächstbenachbarten Leiterbahnabschnitt und die gleiche Breite wie ihr jeweils nächstbenachbarter Leiterbahnabschnitt auf. Hierdurch kann eine besonders gleichmäßige Transparenz der Leiterbahnanordnung in der Hauptebene des Grundkörpers bzw. der Leiterbahnanordnung erzielt werden.

Weiter bevorzugt weisen zumindest 80% der Leiterbahnabschnitte den gleichen Abstand zu ihrem jeweils nächstbenachbarten Leiterbahnabschnitt und die gleiche Breite wie ihr jeweils nächstbenachbarter Leiterbahnabschnitt auf.

Um ein möglichst gleichmäßiges optisches Erscheinungsbild zu erhalten, kann die Leiterbahnanordnung mehrere zur Anbindung der Leuchtmittel redundante oder funktionslose Leiterbahnabschnitte aufweisen.

Die Leiterbahnen können aus einem Metall, insbesondere aus Gold, Silber und/oder Aluminium, ausgebildet sein. Vorzugsweise sind die Leiterbahnen aus Kupfer ausgebildet. Im Gegensatz zu transparenteren Leitern, beispielsweise aus Indiumzinnoxid (ITO), weist Kuper eine sehr hohe elektrische Leitfähigkeit auf. Die Leiterbahnen weisen vorzugsweise eine Dicke zwischen 5 µm und 35 µm senkrecht zur Hauptebene des Grundkörpers auf. Die Leiterbahnen können über zumindest eine Zwischenschicht, d.h. zumindest mittelbar, mit dem Grundkörper verbunden sein. Vorzugsweise sind die Leiterbahnen unmittelbar auf dem Grundkörper angeordnet, sodass sich die Herstellung der Leuchtanzeige signifikant vereinfacht.

Die Leuchtmittel sind vorzugsweise in Form einer Matrix - mittelbar oder unmittelbar - an der Leiterbahnanordnung angeordnet. Die Leiterbahnen eines ersten elektrischen Spannungspols, d.h. dem Pluspol oder Minuspol, für die Leuchtmittel sind vorzugsweise überwiegend auf einer ersten Seite der Hauptebene des Grundkörpers angeordnet und die Leiterbahnen eines zweiten elektrischen Spannungspols für die Leuchtmittel sind vorzugsweise überwiegend auf der zweiten Seite der Hauptebene des Grundkörpers angeordnet, wobei die zweite Seite der ersten Seite gegenüberliegt.

Da sich die Leiterbahnen hierdurch in unterschiedlichen Ebenen befinden, können sich die Leiterbahnen kollisionsfrei kreuzen. Um die Leuchtmittel nur auf der ersten Seite der Hauptebene des Grundkörpers anordnen zu können, kann der Grundkörper zumindest eine Durchkontaktierung von der ersten Seite zur zweiten Seite aufweisen. Bevorzugt ist im Bereich der Mehrzahl der Leuchtmittel eine Durchkontaktierung des Grundkörpers vorgesehen.

Die Leiterbahnen des ersten elektrischen Spannungspols sind vorzugsweise zeilenweise elektrisch verbunden und die Leiterbahnen des zweiten elektrischen Spannungspols sind vorzugsweise spaltenweise elektrisch verbunden. Hierdurch kann die Leuchtanzeige konstruktiv besonders einfach ausgebildet werden.

Die Mehrzahl der Leuchtmittel sind vorzugsweise derart zumindest mittelbar an dem Grundkörper angeordnet sind, dass die Hauptabstrahlrichtung der Leuchtmittel in den Grundkörper weist. Die Leuchtmittel sind somit im Flipchip-Verfahren aufgebracht, sodass die den Leuchtmitteln gegenüberliegende Seite des Grundkörpers eben ausgebildet ist und dadurch eben auf ein Objekt aufbringbar ist. Hierdurch ist die Leuchtanzeige insbesondere blasenfrei auf eine Glasscheibe montierbar.

Gemäß der Erfindung ist der Grundkörper in Form einer Folie ausgebildet. Die Leuchtanzeige kann dadurch flexibel auf Fassaden, Fensterscheiben oder dergleichen aufgebracht werden. Die Folie ist vorzugsweise in Form einer Kunststofffolie, insbesondere in Form einer PET-Folie (Polyethylenterephthalat-Folie) ausgebildet. Erfindungsgemäß wird unter einer Folie ein eigenständiges, dünnes, insbesondere isolierendes, Blatt mit einer Dicke von weniger als 3 mm, insbesondere weniger als 1 mm, verstanden. Leiterbahnen zur elektrischen Anbindung der Leuchtmittel sind bevorzugt aus einer auf die Folie abgeschiedenen Metallschicht geätzt. Der Grundkörper kann weiter bevorzugt in Form einer Klebefolie ausgebildet sein. Alternativ dazu kann der Grundkörper in Form einer Adhesivefolie ausgebildet sein. Die Leiterbahnanordnung ist dadurch mehrfach rückstandslos auf eine ebene Fläche aufbringbar und wieder entfernbar.

Die Leiterbahnanordnung und die Leuchtmittel können zumindest teilweise mit einer Schutzbeschichtung, d.h. einem Coating, für den Außeneinsatz versehen sein.

Der Grundkörper kann weitestgehend lichtundurchlässig ausgebildet sein. Alternativ oder zusätzlich dazu kann der Grundkörper bedruckt sein.

Eine besonders kompakte, robuste und stromsparende Leuchtanzeige wird erreicht, wenn die Mehrzahl der Leuchtmittel Leuchtdioden (LEDs) aufweisen. Die Leuchtdioden können in Form von organischen Leuchtdioden ausgebildet sein. Vorzugsweise weisen alle Leuchtmittel Leuchtdioden auf. Die Mehrzahl der Leuchtmittel, insbesondere alle Leuchtmittel, weisen weiter bevorzugt RGB-Leuchtdioden auf.

Im Gegensatz zu Großbildfernsehern weisen die Leuchtmittel vorzugsweise zueinander einen Abstand von mehr als 30mm, insbesondere von mehr als 40mm, besonders bevorzugt von mehr als 50mm auf. Hierdurch bleibt die optische Transparenz der Leuchtanzeige sicher gewährleistet.

Zusätzlich zu den Leuchtmitteln kann die Leuchtanzeige zumindest einen Sensor, insbesondere einen Lichtsensor, vorzugsweise in Form einer Photodiode, aufweisen. Die Leuchtanzeige kann hierdurch beispielsweise auf einfallendes Sonnenlicht reagieren und die Leuchtstärke der Leuchtmittel entsprechend anpassen.

Die Leuchtanzeige weist eine Steuereinheit zur Steuerung der Leuchtmittel auf. Die Steuereinheit ist auf dem Grundkörper angeordnet und/oder weist eine Platine auf, die durch ein Fügeverfahren an der Leiterbahnanordnung angeordnet ist, insbesondere an die Leiterbahnanordnung gelötet oder genietet ist. Vorzugsweise ist die Platine an die Leiterbahnanordnung geklebt oder laserpunktgelötet. Die Steuereinheit weist einen Leuchtmitteltreiber und eine Mikrocontrollersteuerung zum Empfang und Dekodieren von Bilddaten oder Filmdaten auf, auf deren Basis die Leuchtmittel ansteuerbar sind.

Bezüglich der Hauptebene der Leiterbahnanordnung ist die Steuereinheit vorzugsweise auf der gleichen Seite der Leiterbahnanordnung montiert wie die Leuchtmittel und/oder der zumindest eine Sensor. Die Bestückung der Leiterbahnanordnung mit Bauelementen kann dadurch ausschließlich von einer Seite der Hauptebene des Grundkörpers erfolgen, wodurch die Herstellung der Leuchtanzeige deutlich kostengünstiger durchgeführt werden kann.

Die Steuereinheit kann in einem Randbereich der Leuchtanzeige angeordnet sein, sodass der Bereich der Leuchtanzeige wegklappbar ist, insbesondere um den nicht weggeklappten Bereich weiter zu bearbeiten, beispielsweise zu bedrucken und/oder zu verformen. Weiterhin kann die Spannungsversorgung der Leuchtmittel in elektrisch paralleler Schaftungsweise von der Steuereinheit aus erfolgen, sodass ein von der Steuereinheit beabstandeter Teil der Leuchtanzeige von der Steuereinheit entfernbar ist, ohne die Funktionsfähigkeit der an der Leuchtanzeige verbleibenden Leuchtmittel zu beeinträchtigen. Das Entfernen eines Teils der Leuchtanzeige kann besonders flexibel erfolgen, wenn die Steuereinheit in einem Eckbereich der Leuchtanzeige angeordnet ist. Hierdurch können besonders große, von dem Eckbereich beabstandete Teile von der Leuchtanzeige entfernt werden, ohne die Funktionsfähigkeit der an der Leuchtanzeige verbleibenden Leuchtmittel zu beeinträchtigen.

Die Leuchtmittel sind dabei vorzugsweise in Form einer horizontal bzw. vertikal verlaufenden Matrix angeordnet, wobei die Leuchtanzeige derart ausgebildet ist, dass mittels eines durchgehenden horizontalen Schnitts und/oder eines durchgehenden vertikalen Schnitts der Leiterbahnanordnung der mit dem Eckbereich verbleibende Teil der Leiterbahnanordnung seine Funktionsfähigkeit behält. Weiter bevorzugt kann die Leuchtanzeige derart ausgebildet sein, dass mittels eines vom Eckbereich radialen, kreisabschnittförmigen, durchgehenden Schnitts der mit dem Eckbereich verbleibende Teil der Leiterbahnanordnung seine Funktionsfähigkeit behält. Die Entfernbarkeit großer Teile der Leuchtanzeige ist insbesondere dann gegeben, wenn die Leiterbahnabschnitte der Leiterbahnen, die unmittelbar von der Steuereinheit zu den Leuchtmitteln führen, zu mindestens 80%, insbesondere zu mindestens 90%, von der Steuereinheit weg führen.

Der Grundkörper kann zumindest eine Durchgangsausnehmung, insbesondere mehrere Durchgangsausnehmungen, aufweisen, um die Leuchtanzeige leichter auszubilden und blasenfrei an einem Objekt befestigen zu können.

Gemäß der Erfindung ist die Leuchtanzeige aus mehreren Segmenten zusammengesetzt. Die Leuchtanzeige weist dabei mehrere gleiche Segmente aus jeweils einer Steuereinheit, Leuchtmitteln und einer Leiterbahnanordnung auf, wobei die Leuchtanzeige ein Steuergerät zur Steuerung mehrerer Steuereinheiten aufweist. Hierdurch kann die Leuchtanzeige gleichzeitig kostengünstig und große Flächen bedeckend ausgebildet sein. Gemäß der Erfindung handelt es sich bei den Segmenten um gleich ausgebildete Segmente.

Die Grundkörper zumindest einiger Segmente sind vorzugsweise miteinander verbunden, weiter bevorzugt einteilig miteinander ausgebildet. Die Segmente weisen vorzugsweise eine Länge zwischen 10cm und 100cm auf, wobei die Länge der Segmente in Richtung aneinander angrenzender Segmente bestimmt wird.

Die Spannungsversorgung der Steuereinheiten der jeweiligen Segmente erfolgt vorzugsweise mittels einer elektrischen Parallelschaltung. Weiter bevorzugt weist jede Steuereinheit einen Gleichspannungswandler auf, der zur Erniedrigung der an die Steuereinheiten angelegten Spannung ausgebildet ist. Hierdurch können auch weit beabstandete Segmente zuverlässig mit ausreichend hoher Spannung versorgt werden. Die Segmente werden dabei mit einer hohen Spannung versorgt, die an den jeweiligen Steuereinheiten reduziert wird. Die Gleichspannungswandler sind weiter bevorzugt zur Stabilisierung der von den Steuereinheiten ausgegebenen Spannung ausgebildet.

Die Steuereinheiten können identisch ausgebildet sein, um die Leuchtanzeige konstruktiv zu vereinfachen. Die Steuereinheiten sind vorzugsweise zur Kommunikation untereinander ausgebildet. Die Steuereinheiten sind dabei vorzugsweise derart ausgebildet, dass sich bei einem ersten elektrischen Kontakt der Steuereinheiten untereinander eine erste Steuereinheit als Master definiert und sich die weiteren Steuereinheiten jeweils als Slave definieren, wobei die Mastereinheit zur Kommunikation mit dem Steuergerät ausgebildet ist. Vorzugsweise sind die Steuereinheiten so ausgebildet, dass sich eine erste Steuereinheit als Master definiert, die nur eine einzige Steuereinheit als nächsten Nachbarn hat.

Die Segmente sind vorzugsweise zur Ausgabe eines verzerrungsfreien Bildes oder Films ausgebildet, wenn - wie zuvor beschrieben - ein oder mehrere Teile eines Segments oder mehrerer Segmente entfernt wurden.

Zumindest eine Steuereinheit und/oder zumindest ein Steuergerät kann einen Funkempfänger, insbesondere in Form eines WLAN-Funkempfängers, zur unmittelbaren Steuerung der Leuchtmittel und/oder zur Programmierung der Steuereinheit bzw. des Steuergeräts aufweisen. Der Funkempfänger ermöglicht eine Installation der Leuchtanzeige an schwer zugänglichen Orten, beispielsweise im Bereich einer Glasfassade, wobei dennoch die Steuerbarkeit der Leuchtanzeige erhalten bleibt.

Die Leuchtanzeige ist besonders komfortabel an einem beliebigen Objekt montierbar und installierbar, wenn das Steuergerät dazu ausgebildet ist, mittels der Leuchtmittel ein Testbild und/oder einen Testfilm auszugeben, wobei das Steuergerät weiterhin dazu ausgebildet ist, aus dem aufgenommenen Testbild und/oder Testfilm auf die Position der Segmente zu schließen. Hierdurch muss die Position der Segmente nicht vor der Installation der Leuchtanzeige am Objekt festgelegt werden, sondern kann bequem nach der Installation bestimmt werden.

Vorzugsweise weist das Steuergerät eine Schnittstelle, insbesondere eine DVI-Schnittstelle, eine HDMI-Schnittstelle, eine USB-Schnittstelle oder eine LAN-Schnittstelle, zum Einspielen von Bilddaten und/oder Filmdaten auf.

Die Segmente weisen jeweils einen flexiblen Grundkörper in Form der Folie auf. Weiter bevorzugt sind die Grundkörper so flexibel und die Steuereinheiten so klein ausgebildet, dass die Segmente einen minimalen Biegeradius von weniger als 50mm, insbesondere von weniger als 30mm, vorzugsweise von weniger als 20mm aufweisen. LED-Streifen im Stand der Technik weisen in der Regel einen nicht plastisch verformbaren Grundkörper auf. Demgegenüber ist erfindungsgemäß bevorzugt ein Grundkörper aus einem thermoplastischen Kunststoff vorgesehen, um die Leuchtanzeige dauerhaft verformen zu können. Die weitere Bearbeitung der Leuchtanzeige kann in diesem Fall auch eine In-Mould-Decoration und/oder ein Insert-Moulding umfassen.

Bei nicht zur Erfindung gehörigen illustrativen Ausführungsformen kann die Leuchtanzeige einen unbeweglichen Gegenstand aufweisen, an dem der Grundkörper, die Leiterbahnanordnung und die Leuchtmittel angeordnet sind. Bei dem unbeweglichen, d.h. immobilen, Gegenstand, handelt es sich insbesondere um ein Objekt, für das eine Baugenehmigung erforderlich ist.

Die Leuchtanzeige kann bei solchen nicht zur Erfindung gehörigen illustrativen Ausführungsformen eine Fassade, insbesondere eine Glasfassade, eine Werbetafel, eine Dachreling und/oder ein Hinweisschild aufweisen. Der unbewegliche Gegenstand umfasst weiter bevorzugt ein Lichtwerbeelement, insbesondere einen Pylon, eine Attika und/oder ein Fassadenband, an dem die Leiterbahnanordnung angeordnet ist. Die Leuchtanzeige weist besonders bevorzugt ein Corporate-Design-Element, insbesondere eines Autohauses, einer Tankstelle, eines Gastronomiebetriebs, einer Bank, einer Versicherung oder eines Kaufhauses auf. Durch den Abstand von zumindest 10mm der Leuchtmittel zueinander ist die Leuchtanzeige zur Betrachtung in einem gewissen Abstand ausgebildet. Um den Betrachtungsabstand der Leuchtanzeige nicht zu groß zu wählen, sind die Leuchtmittel vorzugsweise in einem Abstand von maximal 120mm, insbesondere maximal 90mm, vorzugsweise maximal 60 mm, zueinander angeordnet.

Vorzugsweise sind die Leuchtmittel in der ersten Richtung gleich weit zueinander beabstandet und/oder in der zweiten Richtung gleich weit zueinander beabstandet. Die Leuchtmittel können in der zweiten Richtung gleich weit beabstandet sein wie in der ersten Richtung.

Die Leuchtmittel können gemeinsam ein- und ausschaltbar sein. Vorzugsweise ist jedes der drei zuvor erwähnten Leuchtmittel, insbesondere die Mehrzahl aller Leuchtmittel der Leuchtanzeige, vorzugsweise alle Leuchtmittel der Leuchtanzeige, individuell ansteuerbar. Hierdurch ist die Leuchtanzeige zur Darstellung verschiedener Bilder einsetzbar.

Weiter bevorzugt sind die Spalten der Matrix aus Leuchtmitteln im rechten Winkel zu deren Zeilen angeordnet.

Die Leuchtmittel können bei nicht zur Erfindung gehörigen illustrativen Ausführungsformen zwischen der Folie und einer Platte angeordnet sein. Die Platte kann zumindest eine Ausnehmung aufweisen, um im Bereich der Ausnehmung eine erhöhte Transparenz für das Licht eines Leuchtmittels aufzuweisen. Auf der Platte kann ein Plakat oder dergleichen angeordnet sein, dessen optische Wirkung durch die Leuchtmittel, insbesondere im Bereich der Ausnehmung, modifiziert wird. Vorzugweise weist die Platte eine Vielzahl von Ausnehmungen auf, die jeweils einem Leuchtmittel zugeordnet sind. Vorzugsweise fluchten die Ausnehmungen mit den ihnen zugeordneten Leuchtmitteln. Zumindest eine Ausnehmung, insbesondere mehrere Ausnehmungen, kann/können in Form einer Durchgangsausnehmung ausgebildet sein. Hierdurch wird wenig Licht der Leuchtmittel durch die Platte absorbiert. Alternativ oder zusätzlich dazu kann die Leuchtanzeige zwei zumindest abschnittsweise transparente Platten aufweisen, die sichtbares Licht um maximal 70%, insbesondere um maximal 40%, vorzugsweise um maximal 10%, reduzieren. Die transparenten Platten sind insbesondere in Form von Glasscheiben ausgebildet. Die Folie verläuft dabei insbesondere im Wesentlichen parallel zu den Platten.

In weiterer Ausgestaltung der Erfindung kann die Leuchtanzeige an einem Panoramadach angeordnet sein. Das Panoramadach ist dabei insbesondere in Form eines Panoramadachs für ein Kraftfahrzeug ausgebildet.

Die Leuchtanzeige kann vorzugsweise zur Darstellung eines Sternenhimmels eingesetzt werden, wobei die Leuchtmittel verschiedene Sterne darstellen. Zumindest eine Leuchtdiode der Leuchtanzeige kann in Form einer High-Power-LED ausgebildet sein. Die High-Power-LED kann eine Leuchtleistung von zumindest 60lm/Watt, insbesondere von zumindest 80lm/Watt, vorzugsweise von zumindest 100lm/Watt aufweisen. Eine solche High-Power-LED kann insbesondere als Leseleuchte, vorzugsweise in einer Leuchtanzeige für ein Panoramadach, eingesetzt werden. Weist die erfindungsgemäße Leuchtanzeige ein Panoramadach und eine Leuchtanzeige mit einer High-Power-LED auf, können mehrere Leuchtmittel als Ambient-Beleuchtung und zumindest ein Leuchtmittel mit einer High-Power-LED, insbesondere mehrere einzelne Leuchtmittel mit einer High-Power-LED, als Leseleuchte(n) eingesetzt werden.

In weiter bevorzugter Ausgestaltung der Erfindung weist die Leuchtanzeige ein Fluggerät auf. Das Fluggerät kann in Form eines Zeppelins ausgebildet sein. Die Leuchtanzeige ist dabei mittelbar oder unmittelbar an dem Fluggerät angeordnet. Das Fluggerät kann hierdurch als großer Werbeträger eingesetzt werden, dessen Außenseite zumindest teilweise optisch durch die Leuchtanzeige modifiziert ist.

Die Leuchtanzeige kann einen Cam-Carpet aufweisen. Unter einem Cam-Carpet wird dabei erfindungsgemäß ein im Wesentlichen flacher Ausleger verstanden, der, insbesondere in Stadien, flach auf einen Boden auflegbar ist und bei senkrechter Draufsicht ein verzerrtes Bild anzeigt. Das verzerrte Bild erscheint für einen Betrachter aus einer einzigen Perspektive unverzerrt. Ein Cam-Carpet ist insbesondere bei Fußballspielen einsetzbar, wobei die unverzerrte Ansicht bei Betrachtung durch eine bestimmte Kameraperspektive gegeben ist. Die Verzerrung des dargestellten Bildes in der Normalperspektive kann ausschließlich durch eine verzerrte Darstellung mittels unverzerrt angeordneter Leuchtmittel erreicht werden. Alternativ oder zusätzlich dazu können die Leuchtmittel auf der Folie verzerrt angeordnet sein. Die Leuchtanzeige kann die Kamera aufweisen, aus deren Perspektive das von der Leuchtanzeige wiedergegebene Bild optisch unverzerrt erscheint.

Die Leuchtanzeige kann eine Abdeckung mit einem Motiv aufweisen, das mehrere Leuchtmittel der Leuchtanzeige überlagert. Durch eine Ansteuerung der Leuchtmittel ist das Erscheinungsbild der Leuchtanzeige, das sich aus dem Licht der Leuchtmittel und dem Motiv zusammensetzt, für einen Betrachter der Leuchtanzeige änderbar. Im abgeschalteten Zustand der Leuchtanzeige ist für einen Betrachter somit praktisch ausschließlich das Motiv der Abdeckung sichtbar, während das Motiv durch die Leuchtmittel änderbar bzw. überlagerbar ist. Die erfindungsgemäße Leuchtanzeige kann daher sowohl im ausgeschalteten Zustand als auch in eingeschaltetem Zustand als Werbeträger bzw. als Informationsträger dienen. Die Leuchtanzeige kann somit als besonders stromsparender Werbeträger eingesetzt werden. Weiterhin kann die Leuchtanzeige als besonders sicheres Informationssystem, beispielsweise für Rettungswege, eingesetzt werden, das auch im ausgeschalteten Zustand, bspw. im Falle eines Stromausfalls, funktioniert. Die Leuchtanzeige kann dabei auch als "augmented poster" bezeichnet werden.

Vorzugsweise ist die Leuchtanzeige dazu ausgebildet, das Motiv bei Dunkelheit von den angeschalteten Leuchtmitteln zu überstrahlen, sodass das Motiv vom Licht der Leuchtmittel dominiert wird. Während bei Tag das Erscheinungsbild der Leuchtanzeige in erster Linie vom Motiv dominiert wird, das eventuell durch die Leuchtmittel modifizierbar ist, wird bei Nacht bzw. Dunkelheit das Erscheinungsbild in erster Linie vom Licht der Leuchtmittel bestimmt. Die Abdeckung verdeckt vorzugsweise die Mehrzahl der Leuchtmittel der Leuchtanzeige, insbesondere alle Leuchtmittel der Leuchtanzeige.

Besonders bevorzugt ist das Motiv der Abdeckung durch einen bedruckten Bereich der Abdeckung ausgebildet. Die statische Abdeckung kann hierdurch auf besonders einfache Art und Weise gefertigt und somit kostengünstig ausgetauscht werden. Das Motiv der Abdeckung kann zumindest teilweise in Form von Fluoreszenzfarbe zur Umwandlung von UV-Licht in sichtbares Licht ausgebildet sein. Die Fluoreszenzfarbe ist dabei vorzugsweise auf die Abdeckung aufgedruckt. Die mit Fluoreszenzfarbe ausgestalteten Teile des Motivs werden dadurch bei Bestrahlung mit UV-Licht sichtbar.

Zumindest ein Leuchtmittel der Leuchtanzeige, insbesondere mehrere Leuchtmittel der Leuchtanzeige, kann/können eine UV-Lichtquelle aufweisen. Die UV-Lichtquelle ist vorzugsweise in Form einer Leuchtdiode ausgebildet. Besonders bevorzugt sind dabei zumindest Teile des Motivs in Form von Fluoreszenzfarbe ausgebildet, sodass diese Teile des Motivs erst beim Einschalten der UV-Lichtquelle sichtbar werden.

In weiter bevorzugter Ausgestaltung der Erfindung weist die Abdeckung ein Gewebe, insbesondere ein bedrucktes Gewebe, auf. Das Gewebe kann in Form eines Kunststoffgewebes ausgebildet sein. Das Gewebe kann in Form eines Segeltuchs ausgebildet sein. Besonders bevorzugst ist das Gewebe in Form eines Nylongewebes ausgebildet. Ein solches Gewebe ist einerseits ideal zum Bedrucken mit einem Motiv und andererseits transparent genug, um das Licht der Leuchtmittel zu transmittieren.

Die Leuchtanzeige kann ein Wegeleitsystem aufweisen. Das Wegeleitsystem kann dazu ausgebildet sein, einen Besucher in einem Gebäude mittels einer Lichtmarkierung zu einem bestimmten Zimmer zu leiten. Beispielsweise kann beim Zugang zu einem Gebäude der Name der zu besuchenden Person angegeben werden, dem eine Farbe zugewiesen wird. Eine Lichtmarkierung in dieser Farbe führt dann zum Zimmer dieser zu besuchenden Person. Nach einer vorgegeben Zeit erlischt die Farbmarkierung wieder und kann einer anderen zu besuchenden Person zugewiesen werden.

Die Leuchtanzeige kann eine Stehle für den Innen- und/oder Außeneinsatz aufweisen. Derlei Stehlen - ohne Abdeckung mit Motiv - sind in öffentlichen Bereichen, beispielsweise Bahnhöfen oder Flughäfen, weit verbreitet. Die Stehle kann ein erstes Segment und ein dem ersten Segment gegenüberliegendes zweites Segment aufweisen. Lediglich das erste Segment kann durch eine Abdeckung mit Motiv zumindest teilweise abgedeckt sein. Alternativ oder zusätzlich dazu kann das zweite Segment durch eine Abdeckung mit Motiv zumindest teilweise abgedeckt sein. Vorzugsweise sind beide Segmente durch eine gemeinsame Abdeckung zumindest teilweise abgedeckt. Die gemeinsame Abdeckung kann in Form einer Haube, die über die Stehle gestülpt ist, ausgebildet sein.

Die Leuchtanzeige ist besonders großflächig und kostengünstig fertigbar, wenn der Grundträger von Rolle zu Rolle bearbeitet wird. Die Bestückung mit Leuchtmitteln und/oder den Steuereinheiten erfolgt dabei vorzugsweise nur von einer Seite des Grundkörpers. Die Leiterbahnen werden bevorzugt galvanisch abgeschieden. Um die Bearbeitbarkeit der Rollen zu erhöhen, weisen die Rollen vorzugsweise eine Breite zwischen 30cm und 90cm, vorzugsweise eine Breite zwischen 50cm und 70cm, und eine Länge von mehr als 100m auf. Die Leuchtanzeige ist dabei vorzugsweise aus mehreren von Rolle zu Rolle gefertigten Bahnen zusammengesetzt. Dies ermöglicht eine Ausbildung der Leuchtanzeige mit einer tennisplatzgroßen Fläche.

Zumindest ein Leuchtmittel und/oder zumindest ein Sensor kann/können in diesem Herstellungsverfahren durch ein Fügeverfahren an der Leiterbahnanordnung angeordnet, insbesondere an die Leiterbahnanordnung gelötet oder genietet sein.

Vorzugsweise ist/sind zumindest ein Leuchtmittel und/oder zumindest ein Sensor an die Leiterbahnanordnung geklebt oder laserpunktgelötet. Die Fügeverfahren Kleben und Laserpunktlöten sind dabei auch bei Grundkörpern einsetzbar, die einen niedrigen Schmelzpunkt, insbesondere unter 200°C, aufweisen.

Das Verfahren zur Herstellung der Leuchtanzeige umfasst das Bearbeiten des Grundträgers von Rolle zu Rolle und bevorzugt eine Wärmebestrahlung des Grundkörpers durch eine mit Durchgangsausnehmungen versehene Endloskette eines Reflow-Ofens. Die Endloskette wirkt dabei als Hitzeschild für den wärmeempfindlichen Grundkörper.

Alternativ oder zusätzlich dazu kann das Herstellen der Leuchtanzeige eine Wärmeverformung umfassen. Dabei können zumindest Teile der Leuchtanzeige zwischen zwei erwärmten Formteilen gewölbt werden. Das Verformen kann eine Vakuumverformung umfassen. Das Verfahren zur Herstellung der Leuchtanzeige kann ein In-Mould-Decoration-Verfahren und/oder ein Insert-Moulding umfassen.

Ein nicht zur Erfindung gehörendes rein illustrativ dargestelltes Verfahren ist ein Verfahren zur Steuerung einer zuvor beschriebenen Leuchtanzeige mit den Verfahrensschritten:
A) Ausgabe eines Testbildes oder eines Testfilms durch die von dem Steuergerät angesteuerten Leuchtmittel;
B) Aufnahme des Testbildes/Testfilms;
C) Einspielen des Testbildes/Testfilms in das Steuergerät;
D) Zuordnung der Position der Segmente anhand des eingespielten Testbildes/Testfilms durch das Steuergerät;
E) Ausgabe eines Bildes oder Films durch die von dem Steuergerät angesteuerten Leuchtmittel auf Grundlage der Zuordnung gemäß Verfahrensschritt D).

Das Verfahren ermöglicht die automatisierte Zuordnung einzelner Segmente der Leuchtanzeige, nachdem diese an einem Objekt installiert wurden. Die Aufnahme des Testbildes bzw. Testfilms kann mittels einer Kamera eines Mobiltelefons oder Tabletts erfolgen.

Das Steuergerät kann eine Software aufweisen, die dazu ausgebildet ist, eine korrigierende perspektivische Verzerrung des durch die Leuchtmittel ausgegebenen Bildes oder Films vorzunehmen. Weiter bevorzugt ist das Steuergerät dazu ausgebildet, eine perspektivische Verzerrung eines aufgenommenen Objektes zu ermitteln. Das Steuergerät kann hierdurch eine perspektivische Verzerrung, die beispielsweise dadurch entsteht, dass eine Leuchtanzeige "über Eck" installiert ist, kompensieren. Dabei wird zunächst die perspektivische Verzerrung anhand des durch die Leuchtmittel ausgegebenen Bildes oder Films ermittelt und anschließend ein solchermaßen verzerrtes Bild über die Leuchtmittel ausgegeben, dass die ermittelte Verzerrung weitgehend kompensiert wird.

Die Leuchtanzeige kann weiterhin eine Korrekturvorrichtung aufweisen, die dazu ausgebildet ist, eine Verschiebung bzw. Verzerrung der Abdeckung zu kompensieren, indem die Leuchtmittel von der Korrekturvorrichtung bzw. dem Steuergerät korrigierend angesteuert werden. Eine Korrekturvorrichtung der Leuchtanzeige kann dazu ausgebildet sein, mittels einer angepassten Ansteuerung mehrerer Leuchtmittel die individuelle Abschattung mehrerer Leuchtmittel durch das Motiv zu korrigieren. Mit anderen Worten ist in diesem Fall die Korrekturvorrichtung dazu ausgebildet, die Leuchtstärke mehrerer Leuchtmittel auf das Motiv der Abdeckung anzupassen. Die Korrekturvorrichtung kann eine Kamera zur Aufnahme eines Fotos und/oder Videos aufweisen, um die Leuchtmittel anhand des aufgenommenen Fotos bzw. Videos angepasst anzusteuern. Alternativ oder zusätzlich dazu kann die Korrekturvorrichtung dazu ausgebildet sein, die Ansteuerung mehrerer Leuchtmittel der Leuchtanzeige unter Berücksichtigung eines mathematischen Modells, das in der Korrekturvorrichtung hinterlegt ist, anzusteuern. In dem mathematischen Modell kann die Transparenz mehrerer Motivteile der Abdeckung hinterlegt sein.

Die Erfindung umfasst weiterhin ein Verfahren zum Betrieb einer zuvor beschriebenen Leuchtanzeige, bei der in Form einer Matrix angeordnete Leuchtmittel reihenweise mit einer Dauer zwischen 100ms und 1s angesteuert werden. Unter einer Reihe wird dabei eine Spalte oder eine Zeile der Matrix verstanden. Alternativ oder zusätzlich dazu kann eine einzelne Reihe / können mehrere Reihen beim reihenweisen Ansteuern der Leuchtmittel übersprungen werden. Hierdurch wird der von der Leuchtanzeige verbrauchte Gesamtstrom primär in vorbestimmten Bereichen der Leuchtanzeige verbraucht, sodass diese Bereiche besonders hell leuchten. Dies erlaubt eine verstärkte Ansteuerung der vorbestimmten Bereiche bei Tageslicht ohne den von der Leuchtanzeige verbrauchten Gesamtstrom zu erhöhen.

Weitere Merkmale und Vorteile der Erfindung ergeben sich aus der nachfolgenden Beschreibung.

Es zeigen:
- Fig. 1: eine schematische Darstellung einer Leuchtanzeige mit einem Gebäude und mehreren an dem Gebäude angeordneten Segmenten, die jeweils eine Leiterbahnanordnung aufweisen;
- Fig. 2a: eine Draufsicht auf eine Leiterbahnanordnung eines Segments;
- Fig. 2b: einen Ausschnitt aus der Leiterbahnanordnung gemäß Fig. 2a;
- Fig. 3: eine perspektivische Ansicht einer Leuchtanzeige mit zwei Glasscheiben;
- Fig. 4: eine perspektivische Ansicht einer Leuchtanzeige mit einer Lochplatte;
- Fig. 5: eine perspektivische Ansicht einer Leuchtanzeige mit einem Panoramadach;
- Fig. 6: eine perspektivische Ansicht einer Leuchtanzeige mit einem Fluggerät;
- Fign. 7a-7c: verschiedene perspektivische Ansichten einer Leuchtanzeige mit einem Cam-Carpet;
- Fig. 8a: eine Draufsicht auf eine weitere Leuchtanzeige mit mehreren Leuchtmitteln im ausgeschalteten Zustand;
- Fig. 8b: eine Draufsicht auf die Leuchtanzeige gemäß Fig. 8a mit mehreren eingeschalteten Leuchtmitteln;
- Fig. 8c: eine Draufsicht auf die Leuchtanzeige gemäß Fig. 8b mit anderen eingeschalteten Leuchtmitteln;
- Fig. 9: eine Draufsicht auf eine weitere Leuchtanzeige mit einer Korrekturvorrichtung;
- Fig. 10: eine Draufsicht auf eine weitere Leuchtanzeige mit einer Durchgangsausnehmung;
- Fig. 11: eine Leuchtanzeige mit einer Stehle;
- Fig. 12: eine perspektivische Ansicht eines Gangs eines Gebäudes mit einer Leuchtanzeige in Form eines Wegeleitsystems;
- Fig. 13: eine Draufsicht auf ein Segment einer gebogenen Leuchtanzeige;
- Fig. 14a: eine schematische Seitenansicht einer Vorrichtung zur Herstellung eines Teils einer Leuchtanzeige; und
- Fig. 14b: eine Schnittansicht eines Kettensegments der Vorrichtung aus Fig. 14a.

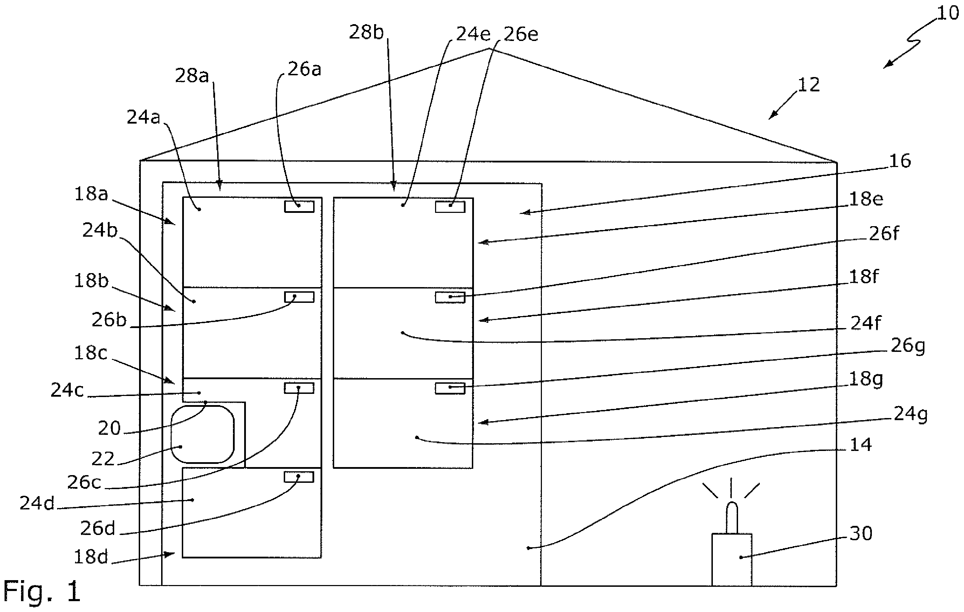

**Fig. 1** zeigt schematisch eine Leuchtanzeige **10.** Die Leuchtanzeige 10 weist ein Gebäude **12** mit einer Glasfassade **14** auf. Weiterhin weist die Leuchtanzeige 10 eine Segmentanordnung **16** mit mehreren Segmenten **18a-g** auf. Die Segmente 18a-g dienen der Anzeige eines Bildes oder Films auf der Glasfassade 14. Die Segmente 18a-g sind dabei so transparent ausgebildet, dass ein sich außerhalb des Gebäudes 12 befindender Betrachter (nicht gezeigt) noch durch die Glasfassade 14 hindurchsehen kann. Teile der Segmente 18a-g sind entfernbar, ohne dass die Funktionsfähigkeit der verbleibenden Teile der Segmente 18a-g beeinträchtigt wird. Dies ist in Fig. 1 beispielhaft im Fall des Segments 18c angedeutet, das im Gegensatz zu den weiteren Segmenten 18a-b und 18d-g einen Beschnitt **20** aufweist, um Platz für einen Träger **22** des Gebäudes 12 zu schaffen. Die Segmente 18a-g sind erfindungsgemäß gleich ausgebildet.

Die Segmente 18a-g weisen jeweils eine Leiterbahnanordnung **24a-g** auf, an der jeweils eine Steuereinheit **26a-g** angeordnet ist. Die Steuereinheiten 26a-g steuern die Leuchtmittel (nicht gezeigt) der Segmente 18a-g. Die Segmente 18a-d und die Segmente 18e-g weisen jeweils elektrisch miteinander verbundene Leiterbahnanordnungen 24a-d bzw. 24e-g auf. Die Leiterbahnanordnungen 24a-d bzw. 24e-g weisen dabei jeweils einen gemeinsamen Grundkörper (in Fig. 1 nicht mit einem Bezugszeichen versehen) auf. Die Segmente 18a-d und die Segmente 18e-g bilden dadurch jeweils eine Segmentbahn **28a, 28b.**

Sobald die Segmentbahnen 28a, 28b mit elektrischer Spannung versorgt sind, bestimmen die Steuereinheiten 26a-d bzw. 26e-g jeweils eine Master-Steuereinheit. Vorzugsweise ist die Leuchtanzeige 10 dabei derart ausgebildet, dass sich eine Steuereinheit zur Master-Steuereinheit bestimmt, deren Leiterbahnanordnung nur eine unmittelbar mit ihr verbundene weitere Leiterbahnanordnung aufweist. Im in Fig. 1 gezeigten Beispiel könnten sich die Steuereinheiten 26a und 26e zu Master-Steuereinheiten bestimmen. Die verbleibenden Steuereinheiten 26b-d bzw. 26f-g bestimmen sich zu Slave-Steuereinheiten, die von den Master-Steuereinheiten 26a bzw. 26e abhängig sind. Die Steuereinheiten 26a-d und 26e-g der Segmentbahnen 28a, 28b bilden jeweils eine Daisy Chain.

Nur die Master-Steuereinheiten 26a, 26e kommunizieren mit einem Steuergerät **30** der Leuchtanzeige 10. Das Steuergerät 30 ist im vorliegenden Fall zur drahtlosen Kommunikation mit den Master-Steuereinheiten 26a, 26e ausgebildet. Alternativ oder zusätzlich dazu kann das Steuergerät 30 über eine Kabelverbindung (nicht gezeigt) zur Kommunikation mit den Steuergeräten 26a, 26e ausgebildet sein.

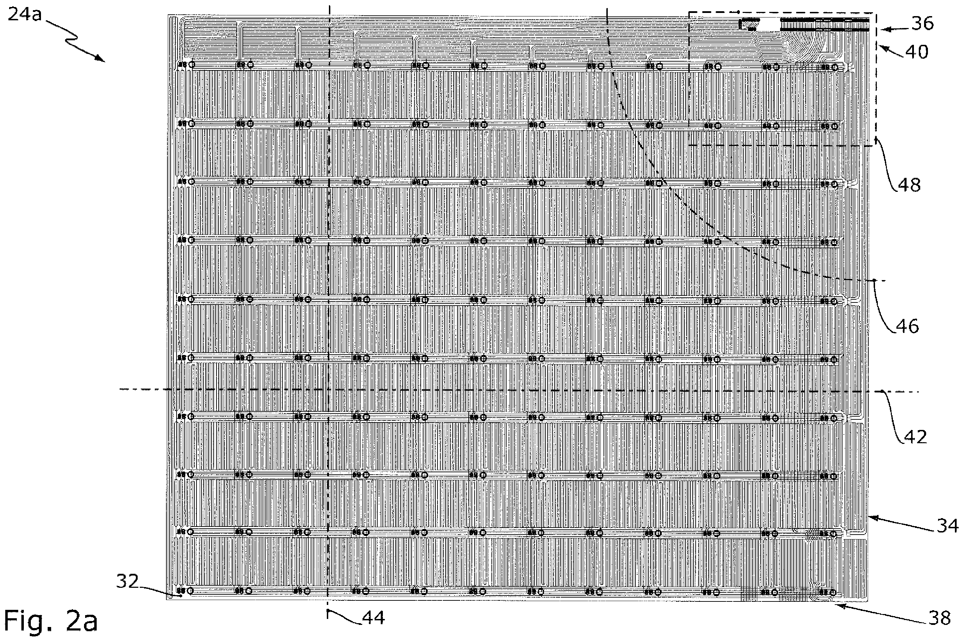

**Fig. 2a** zeigt die Leiterbahnanordnung 24a. Die Leiterbahnanordnung 24a weist einen Grundkörper **32** auf, der in Form einer flexiblen Kunststofffolie ausgebildet ist. Auf dem Grundkörper 32 sind eine Vielzahl von Leiterbahnen **34** angeordnet. Die Leiterbahnen 34 sind aus Kupfer ausgebildet. Die Spannungsversorgung der Leiterbahnanordnung 24a erfolgt über einen Eingang **36.** An einen Ausgang **38** der Leiterbahnanordnung 24a ist eine weitere Leiterbahnanordnung elektrisch anbindbar, im vorliegenden Fall die Leiterbahnanordnung 24b (siehe Fig. 1).

Im Bereich des Eingangs 36 ist die Steuereinheit 26a (siehe Fig. 1) anordenbar. Der Eingang 36 ist in einem Eckbereich **40** der Steuereinheit 24a ausgebildet. Hierdurch kann mittels eines durchgehenden horizontalen Schnitts **42** und/oder eines durchgehenden vertikalen Schnitts **44** der Leiterbahnanordnung 24a der mit dem Eckbereich 40 verbleibende Teil der Leiterbahnanordnung 24a seine Funktionsfähigkeit erhalten. Weiterhin kann mittels eines vom Eckbereich 40 radialen, kreisabschnittförmigen, durchgehenden Schnitts **46** der mit dem Eckbereich 40 verbleibende Teil der Leiterbahnanordnung 24a seine Funktionsfähigkeit erhalten.

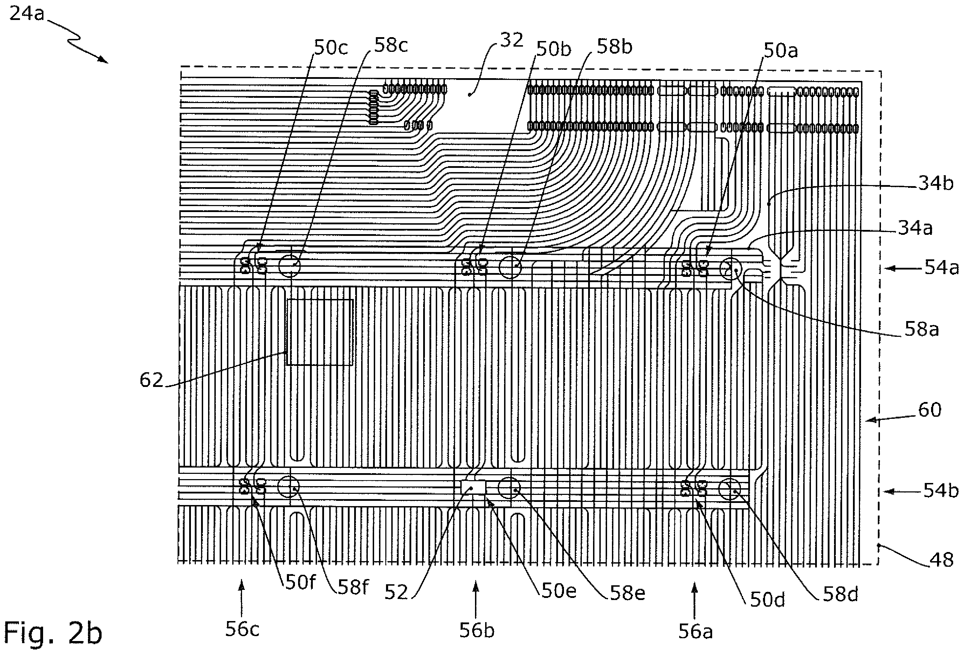

**Fig. 2b** zeigt einen Ausschnitt **48** (siehe auch Fig. 2a) der Leiterbahnanordnung 24a. Anhand des Ausschnitts 48 ist erkennbar, dass die Leiterbahnanordnung 24a mehrere Kontaktstellen **50a-f** für Leuchtmittel, hier für Leuchtdioden, aufweist. In Fig. 2b ist beispielhaft ein Leuchtmittel **52** in Form einer Leuchtdiode auf der Kontaktstelle 50e angeordnet. Das Leuchtmittel 52 kann eine eigene Steuerplatine und/oder ein Gehäuse umfassen. Die Kontaktstellen 50a-c bzw. 50d-f sind jeweils in horizontalen Zeilen **54a, 54b** angeordnet. Weiterhin sind die Kontaktstellen 50a, 50d bzw. 50b, 50e bzw. 50c, 50f jeweils in vertikalen Spalten **56a-c** angeordnet. Mit anderen Worten sind die Kontaktstellen 50a-f in einer horizontalen/vertikalen Matrix angeordnet. Die Zeilen 54a, 54b sind elektrisch über Leiterbahnen verbunden, von denen aus Gründen der Übersichtlichkeit lediglich eine Leiterbahn 34a mit einem Bezugszeichen versehen ist. Die Leiterbahnen der Zeilen 54a, 54b verlaufen auf der in Fig. 2b abgewandten ersten Seite der Hauptebene des Grundkörpers 32. Die Hauptebene des Grundkörpers 32 entspricht der Zeichnungsebene der Fig. 2a und Fig. 2b.

Auf der in Fig. 2b dem Betrachter zugewandten zweiten Seite der Hauptebene des Grundkörpers 32 sind die Leiterbahnen der Spalten 56a-c angeordnet, von denen in Fig. 2b lediglich eine Leiterbahn 34b mit einem Bezugszeichen versehen ist.

Um die Leuchtmittel, beispielsweise das Leuchtmittel 52, nur auf einer der beiden Seiten der Hauptebene des Grundkörpers 32 montieren zu müssen, sind in dem Grundkörper 32 Durchbrüche **58a-f** vorgesehen. Die Durchbrüche 58a-f sind maximal 10mm beabstandet zu jeweils zugehörigen Kontaktstellen 50a-f ausgebildet. Die Leiterbahnen 34 stellen Strukturen einer Bedeckung **60** dar. Wie aus Fig. 2b ersichtlich ist, weist die Bedeckung 60 Leiterbahnabschnitte auf, die zur Stromversorgung der Leuchtmittel redundant oder überflüssig sind. Unter einer redundanten Stromversorgung werden dabei auch Leiterbahnabschnitte verstanden, die sich aus einem gemeinsamen Leiterbahnabschnitt aufzweigen, elektrisch parallel verlaufen und sich wieder vereinigen, wobei der effektive Leiterquerschnitt der Leiterbahn an den elektrisch parallel verlaufenden Leiterbahnabschnitten vergrößert wird. Die Bedeckung 60 weist dabei eine homogene mittlere Transparenz auf, wobei die einzelnen Leiterbahnabschnitte aus einer Entfernung von mindestens 5m mit bloßem Auge nicht mehr erkennbar sind.

In der Hauptebene des Grundkörpers 32 können gedanklich 1cm² große, aneinander stoßende Quadrate definiert werden, von denen in Fig. 2b ein Quadrat **62** mit einem Bezugszeichen versehen ist. In zumindest 85% dieser Quadrate bedeckt die Fläche der Leiterbahnen 34 in der Hauptebene des Grundkörpers 32 den Grundkörper zu 30% bis 60%. Hierdurch wird ein optisch besonders homogener Eindruck der Leiterbahnanordnung 24a erweckt.

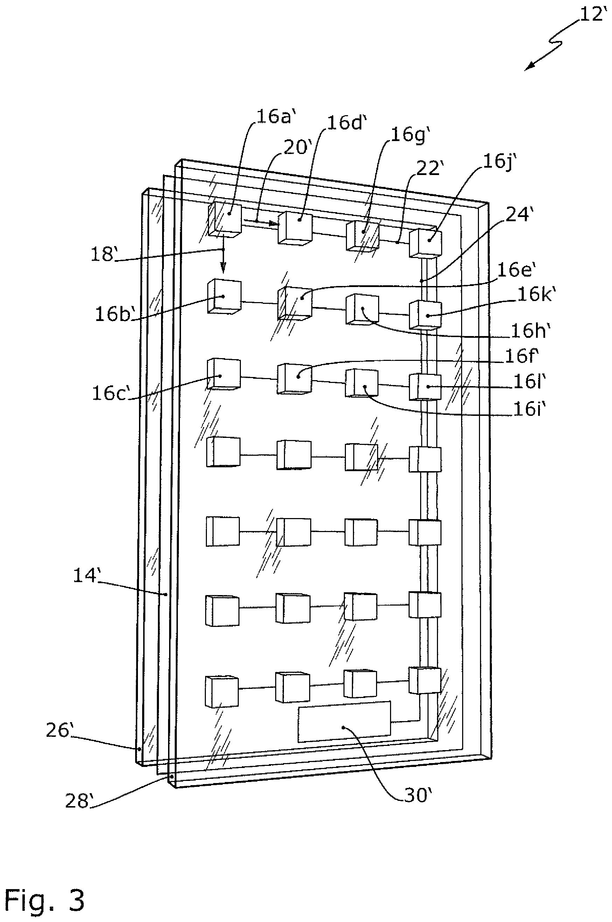

**Fig. 3** zeigt ein nicht zur Erfindung gehörendes illustratives Ausführungsbeispiel einer Leuchtanzeige **12'.** Die Leuchtanzeige 12' weist eine Folie **14'** sowie mehrere Leuchtmittel auf, von denen aus Gründen der Übersichtlichkeit in Fig. 1 lediglich die Leuchtmittel **16a'** - **16l'** mit einem Bezugszeichen versehen sind. Die Leuchtmittel 16a' - 16l' sind in Form einer Matrix auf der Folie 14' angeordnet. Die Leuchtmittel 16a' - 16l' sind dabei spaltenweise und zeilenweise angeordnet. Beispielsweise sind die Leuchtmittel 16a', 16b' und 16c' in einer ersten Richtung **18'** hintereinander in einer Spalte angeordnet. Die Leuchtmittel 16a', 16d', 16g', 16j' sind hintereinander in einer zweiten Richtung **20'** in einer Zeile angeordnet. Die zweite Richtung 20' steht dabei senkrecht auf der ersten Richtung 18'. Weiterhin sind die Leuchtmittel 16b', 16e', 16h' und 16k' in einer weiteren Zeile angeordnet. Die Leuchtmittel 16d', 16e', 16f sind in einer weiteren Spalte angeordnet.

Um die Leuchtanzeige 12' bzw. deren Folie 14' in einem großen Bereich beschneiden zu können, sind die Leuchtmittel 16a' - 16l' zeilenweise miteinander verbunden. Dies ist in Fig. 1 durch eine beispielhaft mit einem Bezugszeichen versehene erste Leitung **22'** angedeutet. Weiterhin ist jeweils ein Leuchtmittel 16j', 16k', 161' jeder Zeile mit einem weiteren Leuchtmittel 16j', 16k', 16l' einer weiteren Zeile durch eine in Fig. 1 beispielhaft mit einem Bezugszeichen versehenen zweiten Leitung **24'** verbunden. Alternativ zu der gezeigten Ausführungsform können auch die Leuchtmittel 16a' - 16l' der Spalten untereinander elektrisch verbunden sein, wobei die einzelnen Spalten elektrisch mit weiteren Spalten verbunden sind. Durch die zuvor beschriebene elektrische Verbindung zwischen den Leuchtmitteln 16a' - 16l' können einzelne Leuchtmittel entfernt werden, ohne die Ansteuerbarkeit der verbleibenden Leuchtmittel 16a' - 16l' zu beeinträchtigen. In der Leuchtanzeige 12' gemäß Fig. 1 können beispielsweise die Leuchtmittel 16b', 16c' mitsamt der Folie 14' im Bereich der Leuchtmittel 16b', 16c' entfernt werden, ohne die Ansteuerbarkeit der verbleibenden Leuchtmittel 16a', 16d' - 16l' zu beeinträchtigen.

Die Leuchtanzeige 12' ist zwischen zwei transparenten Platten **26', 28'** angeordnet. Die transparenten Platten 26', 28' sind in Form von Kunststoffscheiben oder Glasscheiben ausgebildet. Die Ebene der Folie 14' verläuft parallel zur Ebene der Platten 26', 28'. Jedes Leuchtmittel 16a' - 16l' ist individuell ansteuerbar. Die Ansteuerung der Leuchtmittel 16a' - 16l' erfolgt durch eine Steuereinheit **30'.** Jedes Leuchtmittel 16a' - 16l' weist eine RGB-LED auf. Die Folie 14' ist vollständig transparent ausgebildet, wobei die Folie 14' Licht um maximal 20% reduziert.

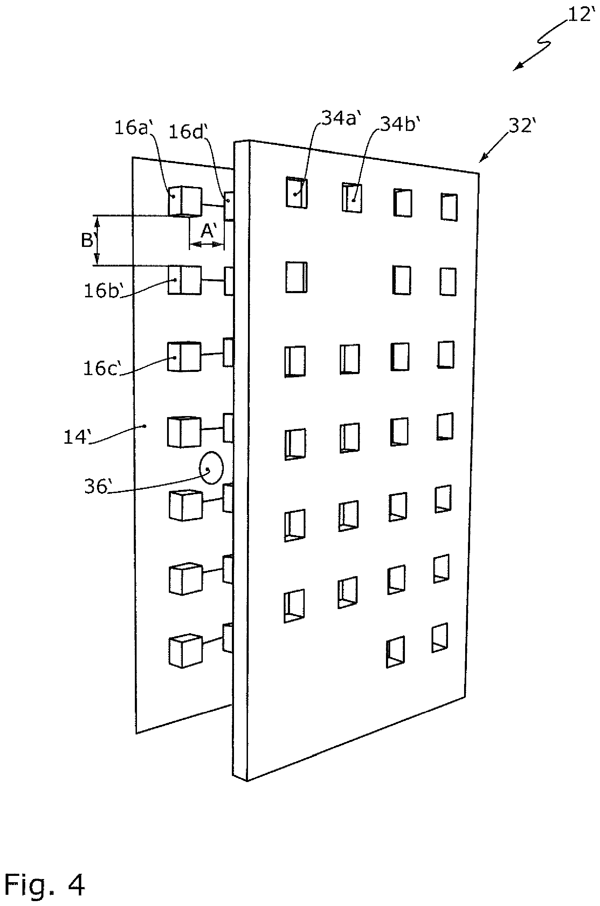

**Fig. 4** zeigt ein nicht zur Erfindung gehörendes illustratives Ausführungsbeispiel einer Leuchtanzeige 12', wobei die Leuchtanzeige 12' eine Folie 14' und mehrere Leuchtmittel aufweist, von denen aus Gründen der Übersichtlichkeit in Fig. 2 lediglich die Leuchtmittel 16a' - 16d' mit einem Bezugszeichen versehen sind. Im Gegensatz zur Leuchtanzeige 12' gemäß Fig. 1 weist die Leuchtanzeige 12' gemäß Fig. 2 eine intransparente Folie 14 auf, d.h. eine Folie, die Licht um minimal 80% reduziert. Die Leuchtmittel 16a' - 16d' sind in Zeilen im Abstand A' beabstandet und in Spalten im Abstand B' beabstandet. Die Abstände A', B' betragen zwischen 10mm und 60mm. Im Ausführungsbeispiel gemäß Fig. 4 sind die Abstände A' und B' gleich groß.

Die die Leuchtmittel 16a' - 16d' aufweisende Seite der Folie 14' ist durch eine Platte **32'** teilweise verdeckt. Durch die Platte 32' wird der Leuchtanzeige 12' eine erhöhte Stabilität verliehen. Hierdurch kann auf der der Folie 14' abgewandten Seite der Platte 32 ein Plakat oder dergleichen (nicht gezeigt) befestigt werden. Weiterhin kann das Plakat oder dergleichen (nicht gezeigt) später entfernt werden, ohne die Leuchtanzeige 12' zu beschädigen. Die Platte 32' weist mehrere Ausnehmungen auf, von denen aus Gründen der Übersichtlichkeit in Fig. 2 lediglich die Ausnehmungen **34a', 34b'** mit einem Bezugszeichen versehen sind. Die Ausnehmungen 34a', 34b' fluchten jeweils mit zugehörigen Leuchtmitteln 16a' - 16d'. Die Ausnehmung 34a' ist dabei in Form einer die Dicke der Platte 32' reduzierenden Vertiefung ausgebildet, während die Ausnehmung 34b' in Form einer Durchgangsausnehmung ausgebildet ist. Um das Gewicht der Leuchtanzeige 12 zu reduzieren, weist die Folie 14 eine Foliendurchgangsausnehmung **36'** auf.

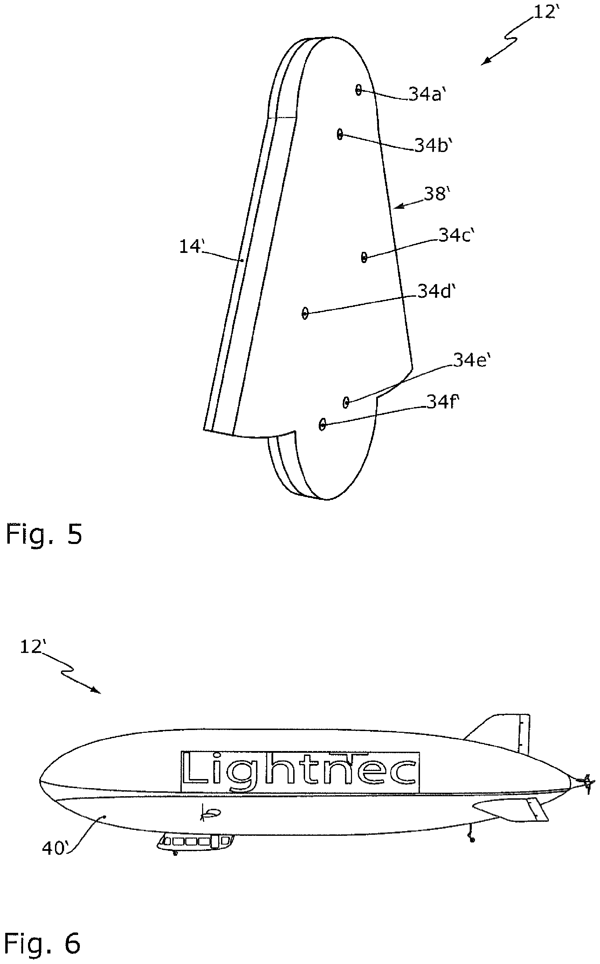

**Fig. 5** zeigt ein weiteres nicht zur Erfindung gehörendes illustratives Ausführungsbeispiel einer Leuchtanzeige 12'. Die Leuchtanzeige 12' weist eine Folie 14' auf, auf der mehrere Leuchtmittel (nicht gezeigt) angeordnet sind. Die Leuchtanzeige 12' weist ein Panoramadach **38'** für ein Kraftfahrzeug auf. Gemäß Fig. 5 ist das Panoramadach 38' in Form einer ebenen Platte ausgebildet. Alternativ dazu kann das Panoramadach 38' - ebenso wie die Platte 32' gemäß Fig. 2 - zumindest eine Wölbung aufweisen. Die Folie 14' kann sich dabei an die Wölbung anschmiegen. Das Panoramadach 38' weist mehrere Ausnehmungen 34a' - 34f auf. Einzelne Ausnehmungen 34a' - 34f können in Form von Vertiefungen oder Durchgangsausnehmungen ausgebildet sein. Die Ausnehmungen 34a' - 34f können mit auf der Folie 14' angeordneten Leuchtmitteln (nicht gezeigt) fluchten.

Zumindest ein Leuchtmittel (nicht gezeigt), beispielsweise der der Ausnehmung 34b' zugeordnete Leuchtmittel, kann eine High-Power-LED aufweisen. Die High-Power-LED weist dabei eine größere Lichtleistung auf als die Leuchtdioden der weiteren Leuchtmittel (nicht gezeigt). Die High-Power-LED kann dadurch als Leseleuchte eingesetzt werden.

**Fig. 6** zeigt eine weitere Leuchtanzeige 12', die ein Fluggerät **40'** in Form eines Zeppelins aufweist. Die Leuchtanzeige 12' weist eine Vielzahl von individuell ansteuerbaren Leuchtmitteln (im Einzelnen nicht gezeigt) auf, durch die im vorliegenden Beispiel gemäß Fig. 4 ein Schriftzug dargestellt wird. Die Leuchtanzeige 12' gemäß Fig. 6 stellt dadurch einen flexibel nutzbaren Werbeträger dar.

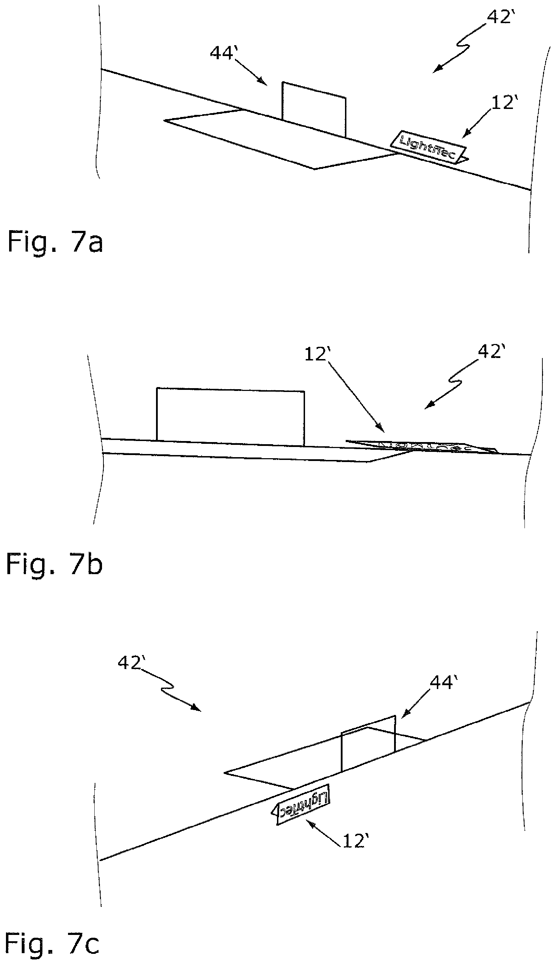

**Fig. 7a** zeigt einen Teil eines Fußballplatzes **42'** mit einem Tor **44'** und einer flach auf dem Boden liegenden Leuchtanzeige 12' in Form eines Cam-Carpet. Ein Schriftzug auf der Leuchtanzeige 12' erscheint aus der in Fig. 7a gezeigten Perspektive unverzerrt und plastisch aus dem Boden zu ragen. Die in Fig. 7a gezeigte Perspektive entspricht der Perspektive einer Hauptkamera, die sich ca. 20 m oberhalb der Seitenlinie auf Höhe der Mittellinie befindet.

**Fig. 7b** zeigt den Fußballplatz 42' aus Sicht eines Fußballspielers. Aus dessen Perspektive erscheint die Wiedergabe der Leuchtanzeige 12' verzerrt. Aus Fig. 7b ist ersichtlich, dass der Cam-Carpet ("Werbeteppich") flach auf dem Boden liegt, sodass er kein physisches Hindernis für den Fußballspieler bildet, sodass kein erhöhtes Verletzungsrisiko durch den Cam-Carpet für den Fußballspieler besteht.

**Fig. 7c** zeigt den Fußballplatz 42' aus Sicht eines Zuschauers auf den Rängen hinter dem Tor 44'. Aus Fig. 7c ist ersichtlich, dass auch hier eine verzerrte Ansicht der Leuchtanzeige 12' gegeben ist. Die Ausbildung einer Leuchtanzeige 12' in Form eines Cam-Carpets bietet den Vorteil, dass dessen Bildanzeige - im Gegensatz zu einem statisch bedruckten Cam-Carpet - animierbar und wechselbar ist. Selbst aus einer senkrechten Perspektive verzerrt dargestellte Videos, die von einem Kamerastandpunkt aus unverzerrt dargestellt sind, sind mit der erfindungsgemäßen Leuchtanzeige 12' erzielbar.

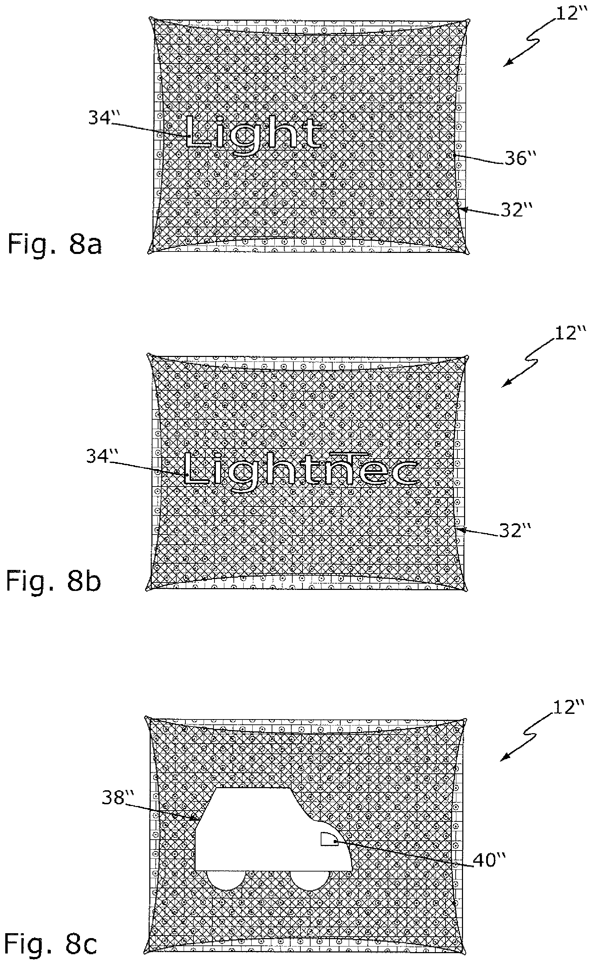

**Fig. 8a** zeigt eine Leuchtanzeige 12" mit einer Abdeckung 32". Die Abdeckung 32" weist ein Motiv **34"** auf, das in Form des Schriftzuges "Light" ausgebildet ist. Die Abdeckung 32" weist ein lichtdurchlässiges Gewebe **36"** auf. Das Gewebe 36" ist insbesondere in Form eines Nylongewebes ausgebildet.

**Fig. 8b** zeigt eine Leuchtanzeige 12" gemäß Fig. 8a, wobei mehrere, aus Gründen der Übersichtlichkeit in Fig. 8b nicht näher bezeichnete, Leuchtmittel eingeschaltet sind, die den Schriftzug "nTec" bilden.

**Fig. 8c** zeigt die Leuchtanzeige 12", wobei aufgrund der Helligkeit der aus Gründen der Übersichtlichkeit in Fig. 8c nicht näher bezeichneten Leuchtmittel der Leuchtanzeige 12" das Motiv 34" (siehe Fig. 8b) für einen Betrachter der Leuchtanzeige 12" praktisch nicht sichtbar ist. Vielmehr wird durch die Leuchtanzeige 12" ein Automobil **38"** dargestellt. Die Darstellung der Leuchtanzeige 12" kann beliebig variiert und animiert werden. Beispielsweise kann die Leuchtanzeige 12" derart betrieben werden, dass ein Blinker **40"** des Automobils 38" blinkt.

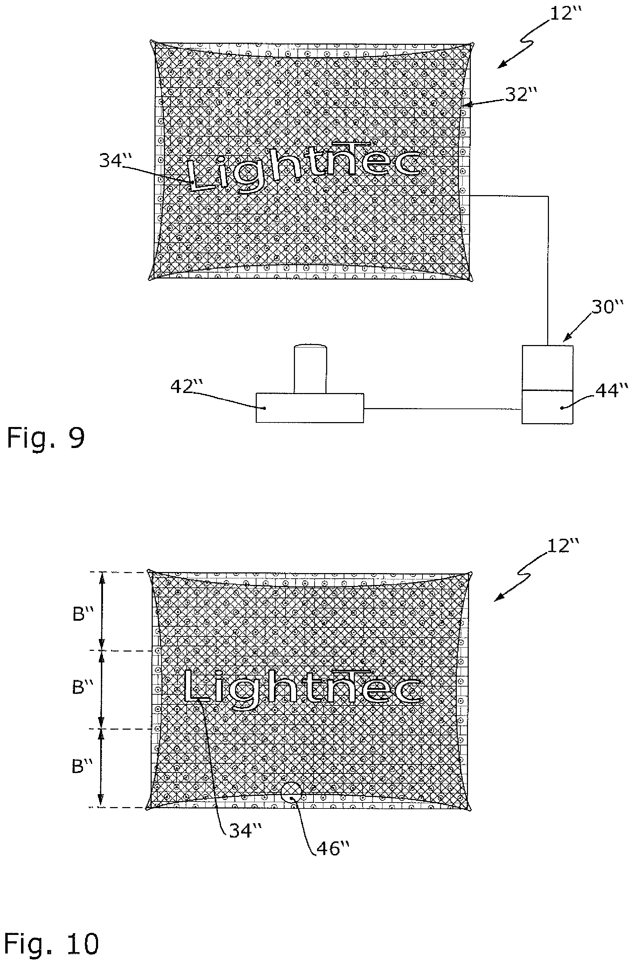

**Fig.** 9 zeigt eine Leuchtanzeige 12", deren Abdeckung 32" verzogen installiert ist. Hierdurch stimmt die Orientierung des Motivs 34" nicht mit der Wiedergabe der Leuchtanzeige 12" überein. Allerdings weist die Leuchtanzeige 12" eine Kamera **42"** auf, die mit einem Steuergerät **30"** verbunden ist. Das Steuergerät 30" weist eine Korrekturvorrichtung **44"** auf, die anhand des Signals der Kamera 42" dazu ausgebildet ist, die Wiedergabe der Leuchtanzeige 12" entsprechend der Abdeckung 34" anzupassen.

**Fig. 10** zeigt eine Leuchtanzeige 12", die aus mehreren Bahnen der Breite **B"** zusammengesetzt ist. Im Fall der Leuchtanzeige 12" gem. Fig. 10 ist das Motiv 34" durch Fluoreszenzfarbe ausgebildet. Die Leuchtanzeige 12" weist zumindest eine, in Fig. 10 nicht mit einem Bezugszeichen versehene, UV-Lichtquelle auf, sodass der Schriftzug "Light" für einen Betrachter nur sichtbar wird, wenn die UV-Lichtquelle eingeschaltet ist. Zur Windlast- und Gewichtsreduktion weist die Leuchtanzeige 12" eine Foliendurchgangsausnehmung **46"** auf.

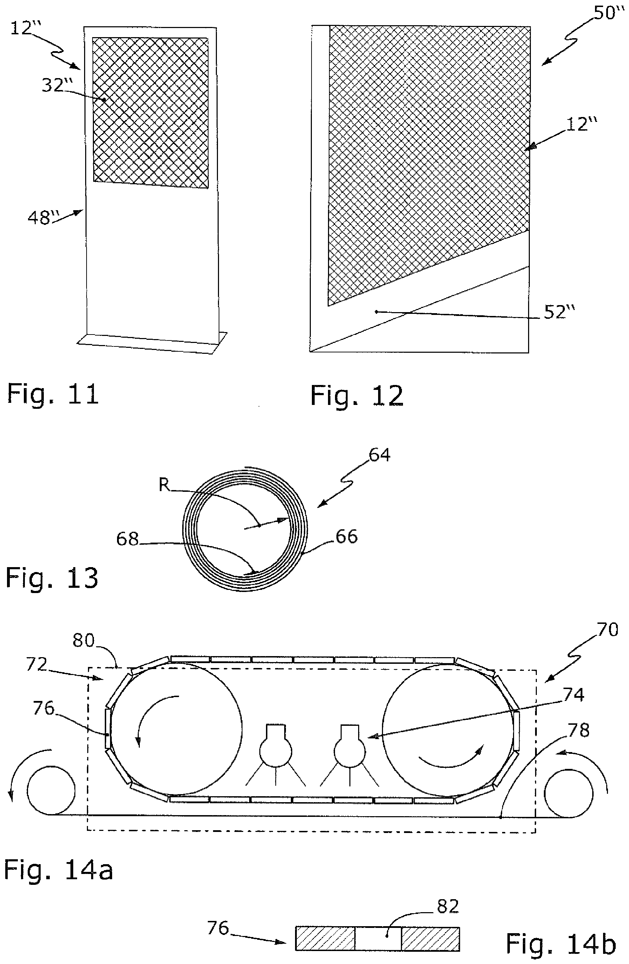

**Fig. 11** zeigt eine Leuchtanzeige 12" mit einer Stehle **48".** Die Stehle 48" weist ein erstes Segment der Leuchtanzeige 12" auf, vor dem eine Abdeckung 32" angeordnet ist. Die Stehle 48" kann auf der in Fig. 11 nicht sichtbaren Rückseite der Stehle 48" ein weiteres Segment der Leuchtanzeige 12" aufweisen, das von einer weiteren Abdeckung 32" zumindest teilweise abgedeckt ist.

**Fig. 12** zeigt einen Teil eines Gebäudes **50"** mit einer Wand **52".** An der Wand 52" ist eine Leuchtanzeige 12" angeordnet. Die Leuchtanzeige 12" ist in Form eines Wegeleitsystems ausgebildet. Alternativ oder zusätzlich zu der Wand 52" kann eine Decke (nicht gezeigt) des Gebäudes 50" eine Leuchtanzeige aufweisen, die in Form einer Wegeleitsystems ausgebildet ist.

**Fig. 13** zeigt ein Segment **64** einer zuvor beschriebenen Leuchtanzeige. Das Segment 64 weist einen Grundkörper **66** und eine Steuereinheit **68** auf. Der Grundkörper 66 ist so biegbar ausgebildet und die Steuereinheit 68 ist so klein ausgebildet, dass das Segment 64 mit einem Innenradius **R** von weniger als 50mm rollbar ist.

**Fig. 14a** zeigt eine Vorrichtung **70** zur Herstellung von zuvor beschriebenen Segmenten einer Leuchtanzeige. Die Vorrichtung 70 weist eine Endloskette **72** auf, die von zumindest einem Wärmestrahler **74** abschnittsweise durchstrahlt wird. Die Endloskette 72 weist mehrere miteinander verbundene plattenförmige Segmente **76** auf. Mehrere aneinandergereihte Grundkörper **78** einer Leuchtanzeige werden - von Rolle zu Rolle bearbeitet - parallel zu Segmenten 76 an den Wärmestrahlern 74 vorbeibewegt. Die Endloskette 72 wird außerhalb eines Gehäuses **80** der Vorrichtung 70 gekühlt.

**Fig. 14b** zeigt ein Segment 76, wobei ersichtlich wird, dass die Segmente 76 eine Durchgangsausnehmung **82** aufweisen, durch die der Grundkörper 78 bestrahlt wird. Die Segmente dienen somit als Hitzeschild für den hitzeempfindlichen Grundkörper 78 (siehe Fig. 14a). Lediglich zur Bauteilbestückung notwendige Bereiche werden durch die Durchgangsausnehmung 82 bestrahlt. Vorzugsweise sind die Segmente 76 gleich ausgebildet.

## Patentansprüche

1. Leuchtanzeige zur Darstellung eines Bildes oder Films, wobei die Leuchtanzeige Folgendes aufweist:
a) Mehrere Leuchtmittel;
b) Eine Leiterbahnanordnung mit einem flächenförmigen Grundkörper und mehreren auf dem Grundkörper angeordneten Leiterbahnen zur Spannungsversorgung der Leuchtmittel, wobei die Leuchtmittel zumindest mittelbar auf der Leiterbahnanordnung angeordnet sind,
wobei der Grundkörper in Form einer Folie, aufweisend ein eigenständiges, dünnes, Blatt mit einer Dicke von weniger als 3mm ausgebildet ist,
und die Leuchtanzeige eine Steuereinheit aufweist, wobei die Steuereinheit einen Leuchtmitteltreiber und eine Mikrocontrollersteuerung zum Empfang und Dekodieren von Bilddaten oder Filmdaten aufweist, auf deren Basis die Leuchtmittel ansteuerbar sind,
i) wobei die Steuereinheit auf dem Grundkörper angeordnet ist, und/oder
ii) die Steuereinheit eine Platine aufweist, die durch ein Fügeverfahren an der Leiterbahnanordnung angeordnet ist,
und bei der die Mehrzahl der Leuchtmittel Leuchtdioden aufweisen und die Leuchtanzeige zumindest drei auf dem Grundkörper angeordnete Leuchtmittel aufweist, wobei jedes dieser Leuchtmittel einen Abstand von mindestens 10mm zum jeweils nächstbenachbarten Leuchtmittel aufweist und wobei ein erstes Leuchtmittel in einer ersten Richtung von einem zweiten Leuchtmittel und in einer anderen, zweiten Richtung von einem dritten Leuchtmittel beabstandet ist;
wobei die Leuchtanzeige mehrere gleiche Segmente aufweist, die jeweils eine Steuereinheit, Leuchtmittel und eine Leiterbahnanordnung aufweisen, wobei die Leuchtanzeige ein Steuergerät zur Steuerung mehrerer Steuereinheiten aufweist.

2. Leuchtanzeige nach Anspruch 1, bei der die Leiterbahnen zumindest einen Teil einer Bedeckung des Grundkörpers darstellen, die den Grundkörper teilweise bedeckt, wobei die Bedeckung die optische Durchlässigkeit der Leiterbahnanordnung senkrecht zur Hauptebene des Grundkörpers um zumindest 80% reduziert, wobei die Bedeckung auf zumindest 85% der Leiterbahnanordnung den Grundkörper zu 30%-60%, gemessen in einem 1cm² großen flächigen Quadrat, bedeckt, um eine weitgehend gleichmäßige mittlere optische Durchlässigkeit der Leiterbahnanordnung zu erzielen.

3. Leuchtanzeige nach einem der vorhergehenden Ansprüche, bei der die Leiterbahnanordnung mehrere zur Anbindung der Leuchtmittel redundante oder funktionslose Leiterbahnabschnitte aufweist.

4. Leuchtanzeige nach einem der vorhergehenden Ansprüche, bei der die Leiterbahnen aus Kupfer ausgebildet sind.

5. Leuchtanzeige nach einem der vorhergehenden Ansprüche, bei der die Mehrzahl der Leuchtmittel Leuchtdioden in Form von RGB-Leuchtdioden aufweisen.

6. Leuchtanzeige nach einem der vorhergehenden Ansprüche, bei der die Leuchtanzeige eine Steuereinheit zur Steuerung der Leuchtmittel aufweist, wobei die Steuereinheit in einem Randbereich der Leuchtanzeige angeordnet ist und die Spannungsversorgung der Leuchtmittel in paralleler Schaltungsweise von der Steuereinheit aus erfolgt, sodass ein von der Steuereinheit beabstandeter Teil der Leuchtanzeige von der Steuereinheit entfernbar ist, ohne die Funktionsfähigkeit der an der Leuchtanzeige verbleibenden Leuchtmittel zu beeinträchtigen.

7. Leuchtanzeige nach einem der vorhergehenden Ansprüche, bei der der Grundkörper aus einem Thermoplast ausgebildet ist.

8. Leuchtanzeige nach einem der vorhergehenden Ansprüche, bei der die Steuereinheit maximal 10%, insbesondere maximal 5%, vorzugsweise maximal 1% der Segmentfläche belegt und die Grundkörper der Segmente flexibel ausgebildet sind, sodass die Segmente mit der Steuereinheit mit einem Innenradius von weniger als 50mm, insbesondere von weniger als 30mm, vorzugsweise von weniger als 20mm, aufrollbar sind.

9. Leuchtanzeige nach einem der vorhergehenden Ansprüche, bei der die Leuchtanzeige eine Abdeckung aufweist, wobei die Abdeckung an ihrer den Leuchtmitteln abgewandten Seite ein Motiv aufweist, dessen Erscheinungsbild für einen Betrachter der Leuchtanzeige änderbar ist.

10. Leuchtanzeige nach Anspruch 9, bei der die Abdeckung ein bedrucktes Gewebe aufweist.

11. Verfahren zur Herstellung einer Leuchtanzeige nach einem der Ansprüche 1 bis 10, wobei der Grundträger von Rolle zu Rolle bearbeitet wird.

12. Verfahren nach Anspruch 11, bei dem das Verbinden der Leuchtmittel mit dem Grundkörper durch ein Reflow-Löten in einem Reflow-Ofen erfolgt, wobei der Grundkörper durch ein Hitzeschild geschützt wird, das Durchgangsausnehmungen im Bereich der Leuchtmittel aufweist und wobei das Hitzeschild in Form einer Endloskette ausgebildet ist, die außerhalb des erhitzten Bereichs des Reflow-Ofens abkühlt.

13. Verfahren zum Betrieb einer Leuchtanzeige nach einem der Ansprüche 1 bis 10, bei dem in einer Matrix angeordnete Leuchtmittel nacheinander reihenweise angesteuert werden, wobei
a) die Reihen jeweils zwischen 100ms und 1s lang angesteuert werden; und/oder
b) einzelne Reihen nicht angesteuert werden.

## Claims

1. Illuminated display for displaying an image or film, wherein the illuminated display has the following:
a) a plurality of illumination means;
b) a strip conductor arrangement having a planar base member and a plurality of strip conductors which are arranged on the base member for the power supply of the illumination means, wherein the illumination means are arranged at least indirectly on the strip conductor arrangement,
wherein the base member is constructed in the form of a film having an independent thin sheet having a thickness of less than 3 mm,
and the illuminated display comprises a control unit, wherein the control unit has an illumination means driver and a microcontroller control for receiving and decoding image data or film data, on the basis of which the illumination means can be controlled,
i) wherein the control unit is arranged on the base member and/or
ii) the control unit has a printed circuit board which is arranged on the strip conductor arrangement by means of a joining method;
and wherein the majority of the illumination means have LEDs and
the illuminated display has at least three illumination means which are arranged on the base member, wherein each of these illumination means has a spacing of at least 10 mm with respect to the next adjacent illumination means, and wherein a first illumination means is spaced apart in a first direction from a second illumination means and is spaced apart in another second direction from a third illumination means,
wherein the illuminated display has a plurality of identical segments each comprising a control unit, illumination means and a strip conductor arrangement, wherein the illuminated display has a control device for controlling a plurality of control units.

2. Illumination means according to claim 1, wherein the strip conductors constitute at least a portion of a cover of the base member, which cover partially covers the base member, wherein the cover reduces the optical permeability of the strip conductor arrangement perpendicularly to the main plane of the base member by at least 80%, wherein the cover over at least 85% of the strip conductor arrangement covers the base member by from 30% to 60%, measured in a 1 cm² large planar square, in order to achieve a substantially uniform mean optical permeability of the strip conductor arrangement.

3. Illuminated display according to either of the preceding claims, wherein the strip conductor arrangement has a plurality of strip conductor portions which are redundant or functionless for connecting the illumination means.

4. Illuminated display according to any one of the preceding claims, wherein the strip conductors are constructed from copper.

5. Illuminated display according to any one of the preceding claims, wherein the majority of the illumination means have LEDs in the form of RGB LEDs.

6. Illuminated display according to any one of the preceding claims, wherein the illuminated display has a control unit for controlling the illumination means, wherein the control unit is arranged in an edge region of the illuminated display and the power supply of the illumination means is carried out with a parallel connection method from the control unit so that a portion of the illuminated display spaced apart from the control unit can be removed from the control unit without impairing the functionality of the illumination means remaining on the illuminated display.

7. Illuminated display according to any one of the preceding claims, wherein the base member is produced from a thermoplastic plastics material.

8. Illuminated display according to any one of the preceding claims, wherein the control unit occupies a maximum of 10%, in particular a maximum of 5%, preferably a maximum of 1% of the segment face and the base members of the segments are constructed in a flexible manner so that the segments can be rolled with the control unit with an inner radius of less than 50 mm, in particular of less than 30 mm, preferably of less than 20 mm.

9. Illuminated display according to any one of the preceding claims, wherein the illuminated display has a cover, wherein the cover at the side thereof facing away from the illumination means has a pattern whose appearance can be modified for an observer of the illuminated display.

10. Illuminated display according to claim 9, wherein the cover has a printed fabric.

11. Method for producing an illuminated display according to any one of claims 1 to 10, wherein the base carrier is processed from roller to roller.

12. Method according to claim 11, wherein the connection of the illumination means to the base member is carried out by means of reflow soldering in a reflow oven, wherein the base member is protected by means of a heat shield which has through-recesses in the region of the illumination means, and wherein the heat shield is constructed in the form of an endless chain which cools outside the heated region of the reflow oven.

13. Method for operating an illuminated display according to any one of claims 1 to 10, wherein illumination means which are arranged in a matrix are controlled in rows one after the other, wherein
a) the rows are each controlled for between 100 ms and 1 s; and/or
b) individual rows are not controlled.

## Revendications

1. Afficheur lumineux destiné à la représentation d'une image ou d'un film, ledit afficheur lumineux comprenant :
a) plusieurs moyens d'éclairage ;
b) un ensemble de pistes conductrices, muni d'un corps de base aplati et de plusieurs pistes conductrices disposées sur ledit corps de base en vue de l'alimentation en tension desdits moyens d'éclairage, lesquels moyens d'éclairage sont implantés au moins indirectement sur ledit ensemble de pistes conductrices,
sachant que
le corps de base est réalisé sous la forme d'un feuil présentant une mince nappe autonome d'une épaisseur inférieure à 3 mm,
et que ledit afficheur lumineux comprend une unité de commande, ladite unité de commande étant dotée d'un excitateur des moyens d'éclairage et d'un pilotage par microcontrôleur, en vue de la réception et du décodage de données d'images ou de données de films sur la base desquelles lesdits moyens d'éclairage peuvent être activés,
i) l'unité de commande étant mise en place sur le corps de base, et/ou
ii) ladite unité de commande étant pourvue d'une platine implantée sur l'ensemble de pistes conductrices par un procédé d'assemblage,
la majeure partie des moyens d'éclairage comportant des diodes électroluminescentes, et l'afficheur lumineux comptant au moins trois moyens d'éclairage implantés sur le corps de base, chacun de ces moyens d'éclairage étant espacé d'une distance d'au moins 10 mm par rapport au moyen d'éclairage respectivement le plus rapproché, et un premier moyen d'éclairage étant espacé d'un deuxième moyen d'éclairage dans une première direction, et d'un troisième moyen d'éclairage dans une autre direction ou seconde direction ; l'afficheur lumineux comprenant plusieurs segments identiques munis, à chaque fois, d'une unité de commande, de moyens d'éclairage et d'un ensemble de pistes conductrices, et ledit afficheur lumineux étant équipé d'un appareil de commande pour piloter plusieurs unités de commande.

2. Afficheur lumineux selon la revendication 1, dans lequel les pistes conductrices matérialisent au moins une partie d'un revêtement du corps de base qui recouvre partiellement ledit corps de base, lequel revêtement réduit d'au moins 80 % la transmission optique de l'ensemble de pistes conductrices perpendiculairement au plan principal dudit corps de base, ledit revêtement recouvrant ledit corps de base sur au moins 85 % dudit ensemble de pistes conductrices, à raison de 30 % - 60 % mesurés dans un carré de 1 cm² de superficie, de manière à obtenir une transmission optique moyenne amplement uniforme dudit ensemble de pistes conductrices.

3. Afficheur lumineux selon l'une des revendications précédentes, dans lequel l'ensemble de pistes conductrices comprend plusieurs tronçons de pistes conductrices redondants ou n'exerçant aucune fonction, en vue du raccordement des moyens d'éclairage.

4. Afficheur lumineux selon l'une des revendications précédentes, dans lequel les pistes conductrices sont réalisées en cuivre.

5. Afficheur lumineux selon l'une des revendications précédentes, dans lequel la majeure partie des moyens d'éclairage comporte des diodes électroluminescentes revêtant la forme de diodes électroluminescentes RVB.

6. Afficheur lumineux selon l'une des revendications précédentes, ledit afficheur lumineux étant muni d'une unité de commande en vue de piloter les moyens d'éclairage, sachant que ladite unité de commande est disposée dans une région marginale dudit afficheur lumineux et que l'alimentation en tension desdits moyens d'éclairage s'opère en mode branchement parallèle, à partir de ladite unité de commande, de sorte qu'une partie de l'afficheur lumineux, située à distance de l'unité de commande, peut être dissociée d'avec ladite unité de commande sans affecter négativement l'aptitude fonctionnelle des moyens d'éclairage demeurant sur ledit afficheur lumineux.

7. Afficheur lumineux selon l'une des revendications précédentes, dans lequel le corps de base est réalisé en une matière thermoplastique.

8. Afficheur lumineux selon l'une des revendications précédentes, dans lequel l'unité de commande occupe au maximum 10 %, notamment 5 % au maximum, de préférence 1 % au maximum de la surface des segments, et les corps de base desdits segments sont de réalisation flexible, de telle sorte que lesdits segments puissent être enroulés, conjointement à ladite unité de commande, avec un rayon interne inférieur à 50 mm, notamment inférieur à 30 mm, de préférence inférieur à 20 mm.

9. Afficheur lumineux selon l'une des revendications précédentes, ledit afficheur lumineux étant pourvu d'un revêtement, lequel revêtement comporte, au niveau de sa face pointant à l'opposé des moyens d'éclairage, un motif dont l'apparence peut être modifiée pour un observateur dudit afficheur lumineux.

10. Afficheur lumineux selon la revendication 9, dans lequel le revêtement comporte un tissu imprimé.

11. Procédé de fabrication d'un afficheur lumineux conforme à l'une des revendications 1 à 10, le support de base étant traité rouleau après rouleau.

12. Procédé selon la revendication 11, dans lequel la liaison des moyens d'éclairage avec le corps de base est instaurée par un brasage par refusion, dans un four de refusion, ledit corps de base étant protégé par un écran thermique comportant des évidements de passage dans la région desdits moyens d'éclairage, et ledit écran thermique étant réalisé sous la forme d'une chaîne sans fin qui se refroidit à l'extérieur de la zone chauffée dudit four de refusion.

13. Procédé d'actionnement d'un afficheur lumineux conforme à l'une des revendications 1 à 10, dans lequel des moyens d'éclairage, logés dans une matrice, sont activés les uns après les autres par rangées, sachant que
a) lesdites rangées sont activées, à chaque fois, pour une durée comprise entre 100 ms et 1s ;
et/ou
b) que des rangées individuelles ne sont pas activées.
